(19) Europäisches Patentamt

European Patent Office

Office européen des brevets

(11) Veröffentlichungsnummer: **0 225 938**
**A1**

## (12) EUROPÄISCHE PATENTANMELDUNG

(21) Anmeldenummer: 85116347.7

(22) Anmeldetag: 20.12.85

(51) Int. Cl.⁴: **G01S 7/52** , G01S 15/10 , H03L 7/06

(43) Veröffentlichungstag der Anmeldung:
**24.06.87 Patentblatt 87/26**

(84) Benannte Vertragsstaaten:
**AT BE CH DE FR GB IT LI LU NL SE**

(71) Anmelder: **Honeywell Regelsysteme GmbH**
**Kaiserleistrasse 55**
**D-6050 Offenbach am Main(DE)**

(72) Erfinder: **Drefahl, Dieter, Dr.**
**Pferdslache 13**
**D-6450 Hanau(DE)**

(74) Vertreter: **Herzbach, Dieter et al**
**Honeywell Europe S.A. Holding KG Patent-**
**und Lizenzabteilung Kaiserleistrasse 55**
**Postfach 184**
**D-6050 Offenbach am Main(DE)**

(54) **Verfahren zum Betrieb einer Sende/Empfangsschaltung und Vorrichtung zur Durchführung des Verfahrens.**

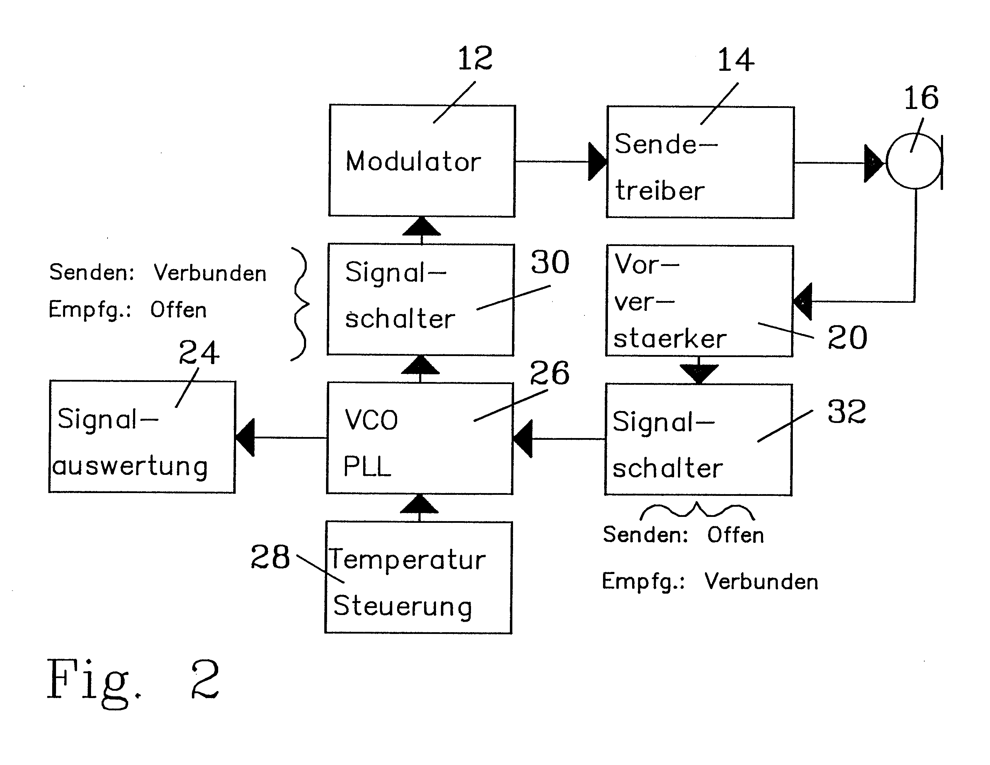

㉗ Es wird ein Verfahren zum Betrieb einer Sende/Empfangsschaltung mit einem durch eine modulierte Trägerfrequenz im Sendebetrieb ansteuerbaren Ultraschallwandler (16) angegeben, bei welchem eine frequenzselektive Einrichtung (26), die einen spannungsgesteuerten Oszillator (VCO) aufweist, für den Empfang von reflektierten Echosignalen verwendet wird. Der spannungsgesteuerte Oszillator (VCO) der frequenzselektiven Einrichtung (26) wird temperaturabhängig geregelt, so daß die von ihm erzeugte Frequenz der veränderten Eigenfrequenz des Ultraschallwandlers (16) nachgeführt wird. Im Sendebetrieb wird die Frequenz des spannungsgesteuerten Oszillators (VCO) als zu modulierende Trägerfrequenz benutzt, so daß im Empfangsbetrieb die frequenzselektive Einrichtung (26) automatisch auf die Empfangsfrequenz abgestimmt ist (Fig. 2).

Fig. 2

EP 0 225 938 A1

# Verfahren zum Betrieb einer Sende/Empfangsschaltung und Vorrichtung zur Durchführung des Verfahrens

Die vorliegende Erfindung bezieht sich auf ein Verfahren zum Betrieb einer Sende/Empfangsschaltung nach dem Gattungsbegriff des Patentanspruches 1 sowie auf eine Vorrichtung zur Durchführung dieses Verfahrens. Das erfindungsgemäße Verfahren dient insbesondere dem störsicheren Empfang eines Ultraschallsignales.

Es ist bekannt, eine relativ hohe, auf die Eigenfrequenz eines Ultraschallwandlers abgestimmte Frequenz nach einem beliebigen Modulationsverfahren zu modulieren und nach Verstärkung von dem Ultraschallwandler abzustrahlen. Das von einem zu messenden Objekt reflektierte Ultraschallecho wird ggf. von dem gleichen Wandler empfangen und nach entsprechender Verstärkung ausgewertet. Üblicherweise wird die Laufzeit zwischen ausgesendetem und empfangenem Signal gemessen, wobei die Detektierung auf der Vorder- oder Rückflanke des modulierten Signales erfolgen kann. Auch kann von einem Verfahren Gebrauch gemacht werden, wie es Gegenstand der älteren europäischen Patentanmeldung 85 115 287.6 ist.

Mit einer frequenzselektiven Einrichtung, wie beispielsweise einem schmalbandigen Filter im Empfangszweig, läßt sich die Störsicherheit hinsichtlich des Empfangssignales wesentlich steigern. Luftgekoppelte Schallwandler weisen eine relativ starke Temperaturabhängigkeit ihrer Eigenfrequenz auf. Wegen dieser Temperaturabhängigkeit der durch den Wandler abstrahlbaren Frequenz muß die Selektivfrequenz des Filters der Sendefrequenz nachgeführt werden, wobei dies beispielsweise in der Weise geschehen kann, wie dies in der vorstehend erwähnten älteren Patentanmeldung dargestellt und beschrieben ist. Dort wird die Frequenz eines in einer Phasenverriegelungsschleife enthaltenen spannungsgesteuerten Oszillators nachgeregelt, d.h. es wird ein größerer Frequenzbereich durchgesteuert, in welchem die Empfangsfrequenz irgendwo liegt, so daß beim Erreichen des Fangbereiches der Phasenverriegelungsschleife diese einrastet.

Es ist die Aufgabe der vorliegenden Erfindung, ein Verfahren der eingangs genannten Art in der Weise zu verbessern, daß auf eine automatische Frequenzregelung auf der Empfangsseite verzichtet werden· kann. Die Lösung dieser Aufgabe gelingt gemäß den kennzeichnenden Merkmalen des Patentanspruches 1. Eine vorteilhafte Vorrichtung zur Durchführung des erfindungsgemäßen Verfahrens ist den Unteransprüchen entnehmbar.

Anhand der Figuren der beiliegenden Zeichnung sei im folgenden das bekannte Verfahren kurz und das erfindungsgemäße Verfahren in näheren Einzelheiten erläutert. Es zeigen:

Fig. 1 eine bekannte Sende/Empfangsschaltung; und

Fig. 2 eine erfindungsgemäß modifizierte Sende/Empfangsschaltung.

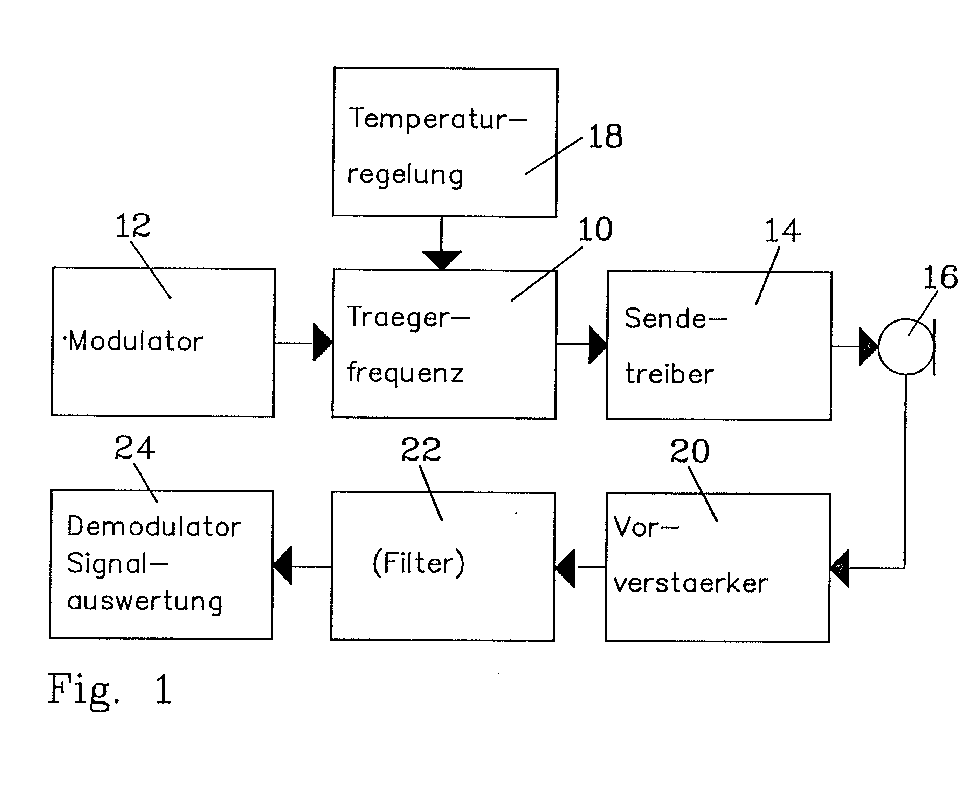

Gemäß Fig. 1 wird die durch einen Oszillator 10 vorgegebene Trägerfrequenz durch einen Modulator 12 moduliert. Im einfachsten Fall - schaltet der Modulator 12 die Trägerfrequenz ein und aus, was zu einer amplituden Modulation mit einem Modulationsgrad zwischen 100 und 0% führt. Die modulierte Trägerfrequenz steuert über einen Sendetreiber 14 einen Ultraschallwandler 16 an. Da die Eigenfrequenz des Ultraschallwandlers 16 stark temparaturabhängig ist, kann man den die Trägerfrequenz erzeugenden Oszillator 10 als spannungsgesteuerten Oszillator (VCO) ausbilden und dessen Frequenz z.B. über einen temperaturabhängigen Widerstand 18 (NTC) regeln.

Das von dem gleichen oder auch einem anderen Ultraschallwandler 16 empfangene Echosignal wird beim Empfang über einen Vorverstärker 20 einer frequenzselektiven Einrichtung, wie z.B. einem Filter 22 zugeführt, dessen Mittenfrequenz auf die Trägerfrequenz abgestimmt ist. Das ausgefilterte Signal kann nach entsprechender Demodulation in einer Einrichtung 24 ausgewertet werden, wobei eine Triggerung auf der Vorder-oder Rückflanke der Einhüllenden erfolgt und die Laufzeit zwischen gesendetem und empfangenem Signal gemessen wird. Die Auswertung kann auch nach dem Verfahren erfolgen, wie es in der älteren europäischen Patentanmeldung 85 115 287.6 beschrieben ist. In jedem Fall muß, damit das Empfangssignal auswertbar ist, die Mittenfrequenz des Filters der sich ändernden Trägerfrequenz nachgeführt werden. Bei Verwendung einer Phasenverriegelungsschleife (PLL) als frequenzselektive, Einrichtung geschieht dies durch Nachregelung der Frequenz des in der Phasenverriegelungsschleife enthaltenen spannungsgesteuerten Oszillators (VCO). Unter Nachregelung ist hierbei nicht die temperaturabhängige Vorgabe einer Frequenz für den spannungsgesteuerten Oszillator zu verstehen, sondern das Durchsteuern eines größeren Frequenzbereiches, in welchem die Empfangsfrequenz irgendwo liegt, so daß beim Erreichen des Fangbereiches der Phasenverriegelungsschleife diese einrastet. Will man z.B. auf der Vorderflanke des reflektierten Echosignales triggern, so liegt im bekannten Fall überhaupt keine Zeit vor, um den Frequenzbereich durchzusteuern.

Bei der erfindungsgemäßen Schaltungsanordnung gemäß Fig. 2 entfällt diese Frequenznachregelung, so daß bezüglich der Signalauswertung keinerlei Beschränkungen vorliegen.

Eine frequenzselektive Einrichtung 26, insbesondere eine Phasenverriegelungsschleife (PLL), weist einen spannungsgesteuerten Oszillator (VCO) auf, dessen Frequenz z.B. über einen NTC-Widerstand 28 temperaturabhängig nachgeführt wird. Der NTC-Widerstand 28 wird dabei so gewählt, daß sein Temperaturverhalten der Eigenfrequenzänderung des Ultraschallwandlers 16 angepaßt ist. Die Frequenz des spannungsgesteuerten Oszillators wird nunmehr als Trägerfrequenz für das zu sendende Signal benutzt, in dem es über einen ersten Schalter 30 auf den Modulator 12 gegeben wird, der z.B. die Trägerfrequenz ein-und ausschaltet. Über den Sendetreiber 14 wird sodann der Ultraschallwandler 16 mit der modulierten Trägerfrequenz angesteuert, so daß er ein Schallsignal mit entsprechender Frequenz abstrahlt.

Nach Abstrahlung des modulierten Trägerfrequenzsignales durch den Ultraschallwandler 16 wird der Schalter 30 aufgetrennt und ein zweiter Schalter 32 im Eingangszweig der frequenzselektiven Einrichtung 26 geschlossen, so daß beim Empfang eines reflektierten Echosignales dieses nach Vorverstärkung in dem Vorverstärker 20 der frequenzselektiven Einrichtung 26 zugeführt wird. Bei Verwendung einer Phasenverriegelungsschleife, die immer einen spannungsgesteuerten Oszillator beinhaltet, liegt nunmehr die empfangene Trägerfrequenz automatisch im Fangbereich der Phasenverriegelungsschleife. Ist die Phasenverriegelungsschleife als Tondecoder ausgebildet, der beim Vorliegen eines Signales der "richtigen Frequenz" und ausreichender Amplitude sein Ausgangssignal binär ändert, so kann jetzt z.B. das erstmalige Ansprechen (Vorderflankentriggerung), das Beenden des Ansprechens (Hinterflankentriggerung) oder die Dauer des Ansprechens (Phasenvergleich) für die Laufzeitmessung ausgewertet werden.

Da bei dieser gewählten Schaltungsanordnung die Mittenfrequenz der frequenzselektiven Einrichtung 26 (PLL bzw. Tondecoder) die Sendefrequenz zwangssynchronisiert, liegt der nahezu ideale Fall eines extrem steilflankigen Filters (Fangbereich der PLL) mit sehr geringer Bandbreite von z.B. weniger als 1% vor.

## Ansprüche

1. Verfahren zum Betrieb einer Sende/Empfangsschaltung mit einem durch eine modulierte Trägerfrequenz im Sendebetrieb ansteuerbaren Wandler und mit einer an den Wandler angeschlossenen frequenzselektiven Einrichtung für den Empfang von reflektierten Signalen im Empfangsbetrieb, wobei die frequenzselektive Einrichtung einen spannungsgesteuerten Oszillator aufweist, **dadurch gekennzeichnet,**daß die Frequenz des spannungsgesteuerten Oszillators - (VCO) temperaturabhängig geregelt ist, und daß im Sendebetrieb die Frequenz des spannungsgesteuerten Oszillators als zu modulierende Trägerfrequenz benutzt wird.

2. Vorrichtung zur Durchführung des Verfahrens nach Anspruch 1 mit einer Phasenverriegelungsschleife (26), als frequenzselektive Einrichtung, **dadurch gekennzeichnet,** daß ein erster Schalter (30) angeordnet ist, der im Sendebetrieb den spannungsgesteuerten Oszillator - (VCO) der Phasenverriegelungsschleife (PLL-26) auf einen Modulator (12) im Sendezweig durchschaltet.

3. Vorrichtung nach Anspruch 2, **gekennzeichnet durch** einen zweiten Schalter (32) am Eingang der Phasenverriegelungsschleife (PLL-26), der im Gegentakt zu dem ersten Schalter (30) betätigt wird und im Empfangsbetrieb geschlossen ist.

4. Vorrichtung nach den Ansprüchen 2 und 3, **gekennzeichnet durch** einen auf das Frequenzverhalten des Wandlers (16) abgestimmten temperaturabhängigen Widerstand (NTC-28) zur Vorgabe der Frequenz des spannungsgesteuerten Oszillators (VCO).

Fig. 1

**Fig. 2**

0 225 938

# EUROPÄISCHER RECHERCHENBERICHT

**Europäisches Patentamt**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | GB-A-2 107 870 (GEOTECHNICAL MONITORING) <br> * Seite 2, Zeilen 61-116; Figur 2 * | 1 | G 01 S 7/52 <br> G 01 S 15/10 <br> H 03 L 7/06 |
| A | | 2,4 | |
| | --- | | |
| Y | GB-A-2 155 711 (ALCATEL THOMSON) <br> * Zusammenfassung; Seite 3, Patentansprüche 1-3 * | 1 | |
| | --- | | |
| A | US-A-3 431 496 (R.V. O'DONNELL) <br> * Spalte 2, Zeile 13 - Spalte 4, Zeile 37; Figuren 1,2 * | 1-3 | |
| | --- | | RECHERCHIERTE SACHGEBIETE (Int. Cl.4) |
| A | US-A-3 952 279 (T.M. FREDERIKSEN et al.) <br> * Zusammenfassung; Figur 2 * | 1 | G 01 S <br> H 03 L |
| | --- | | |
| A | WO-A-8 102 472 (SONIC TAPE) <br> * Seite 6, Zeile 12 - Seite 9, Zeile 3; Figur 2 * | 1-3 | |
| | ---          -/- | | |

Der vorliegende Recherchenbericht wurde für alle Patentansprüche erstellt.

| Recherchenort | Abschlußdatum der Recherche | Prüfer |
|---|---|---|
| DEN HAAG | 04-08-1986 | VAN WEEL E.J.G. |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| A | MESSEN+PRÜFEN/AUTOMATIK, Band 19, Nr. 11, November 1983, Seiten 676-678,681, Bad Wörishofen, DE; Th. GAST et al.: "Längenmessung mit Luftschal" * Seiten 678,681, Abschnitte 5,6 * | 1,4 | |

-----

RECHERCHIERTE SACHGEBIETE (Int. Cl.4)

Der vorliegende Recherchenbericht wurde für alle Patentansprüche erstellt.

| Recherchenort DEN HAAG | Abschlußdatum der Recherche 04-08-1986 | Prüfer VAN WEEL E.J.G. |
|---|---|---|